# EUROPEAN PATENT APPLICATION

(11) **EP 0 669 651 A1**
(43) Date of publication of application: **30.08.1995**
(21) Application number: 95300941.2
(22) Date of filing: 15.02.1995
(51) Int. Cl.: H01L 23/367, H01L 23/495

(54) **Method and apparatus for cooling electronic components**

(30) Priority: 28.02.1994 US 203080
(71) Applicant: AT&T Corp., New York, NY 10013-2412 (US)
(72) Inventor: Azar, Kaveh, Westwood, Massachusetts 02090 (US)
(74) Representative: Johnston, Kenneth Graham

(57) **Abstract**

Dissipation of the heat produced by the operation of electronic circuitry may be improved by a heat sink (40) which dissipates the heat produced by an electronic component, such as an integrated circuit (IC) package (10), that is conducted through the component's leadframe to the circuit board (30) on which the component is mounted. Since it has been observed that up to 40-60% of the heat produced by chips in typical plastic IC packages is conducted through the leadframe, considerable additional cooling of the IC package is achieved over conventional heat sink designs by increasing the thermally conductive surface area of the circuit board. In an illustrative example of the invention, a plurality of individual heat dissipating plates (45) are secured to a circuit board around the periphery of an IC package mounted on the circuit board. In another illustrative example of the invention, the leads (20) of an electronic component are integrated with an extended surface providing for increased surface area.

## Description

### Technical Field

This invention relates to the cooling of heat-producing electronic components. More particularly, this invention relates to heat sinks used to cool electronic components which are mounted on circuit boards and the like.

### Background

Effectively dissipating the heat produced by the operation of electronic components is an important concern in optimizing the performance of the circuitry in which those components are used. In addition to optimizing performance, effective heat dissipation also helps to prolong the useful life of those components and enhances both component and system reliability.

To dissipate heat, an electronic component is typically provided with a heat sink made of metal with high thermal conductivity that is attached to the outer surface of the component. Such heats sinks often utilize an array of elongated fins arranged on a common platform where the platform is then bonded or mechanically attached to the top of the electronic component. Cooling fluid, such as air, conducts heat away from the component by means of forced or natural convection. While air cooling may provide simplicity and low cost, it has limited cooling capacity. Thus, some typical air-cooled heat sinks may not be able to adequately dissipate the heat generated by today's high-powered electronic components in certain applications.

### Summary

The need for adequate heat dissipation capabilities noted above is satisfied by a novel heat sink which dissipates the heat produced by an electronic component that is conducted to the circuit board on which the component is mounted.

In an illustrative example of the invention, a heat dissipative element is attached to the circuit board around the periphery of the component. The heat dissipative element may include a plurality of individual plates made of materials with high thermal conductivity that are attached to the circuit board mechanically or bonded to the circuit board by means of an adhesive. In addition to being attached to the board, the plates may also be attached to the component itself, or to the leads of the component, to further improve the dissipation of heat from the component. In another illustrative example of the invention, the leads of the component are integrated with an extended surface allowing heat conducted to the leads to be dissipated.

The discussion in this Summary and the following Brief Description of the Drawings, Detailed Description, and drawings only deal with examples of this invention and is not to be considered in any way a limitation on the scope of the exclusionary rights conferred by a patent which may issue from this application. The scope of such exclusionary rights is set forth in the claims at the end of this application.

### Brief Description of the Drawings

FIG. 1 is an illustrative example of a heat sink in accordance with the invention.

FIG. 2 is a cross-sectional view of the illustrative arrangement of FIG. 1 taken along line 2-2 in FIG. 1.

FIG. 3 is a top view of the illustrative example of the invention shown in FIG. 1

FIGs. 4, 5, 6, and 7 show various illustrative geometric configurations that surfaces of heat dissipating plates forming a heat sink may take in accordance with three examples of the invention.

FIG. 8 shows another illustrative example of a heat sink in accordance with the invention.

FIG. 9 shows an illustrative means for attaching individual heat dissipating plates to an integrated circuit package having slots for receipt of the heat dissipating plates.

FIG. 10 shows another illustrative means for attaching individual heat dissipating plates to an integrated circuit package using a slotted retainer.

FIG. 11 shows another illustrative example of a heat sink in accordance with the invention.

FIG. 12 shows another illustrative example of a heat sink in accordance with the invention.

FIG. 13 shows an illustrative example of a leadframe with an integrated extended surface in accordance with another example of the invention.

### Detailed Description

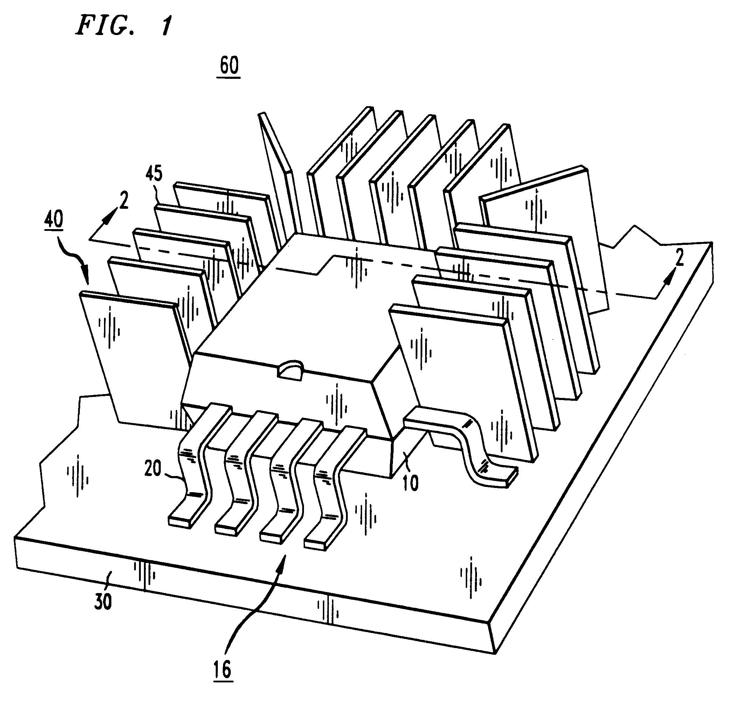

FIG. 1 is an illustrative example of a heat sink in accordance with the invention. Integrated circuit ("IC") package 10 is representative of typical heat-producing electronic components that are well known in the art. IC package 10 includes an internal IC unit (not shown) and a plurality of electrical conductive leads 20. Conductive leads 20 in combination with other elements internal to IC package 10 (not shown) form leadframe 16. Alternatively, the electrical conductors may be pins in a pin grid array. Conductive leads 20 may be formed from well-known materials such as copper or iron-nickel alloy.

The IC unit may be a chip, or a module with at least one chip and other elements and conductors forming a hybrid integrated chip. The IC package includes a housing, typically made of a plastic or ceramic material, which encapsulates and protects the IC unit. IC package 10 could utilize, for example, any one of several leadframe package types such as dual-in-line package ("DIP"), plastic quad flat pack ("PQFP"), plastic leaded chip carrier ("PLCC"), or others that are typically used in electronic packaging art. The IC package could also be one that utilizes leadless or direct chip attachment schemes such a solder bump or chip-on-board attachment. Alternatively, a through-hole package type may also be employed.

IC package 10 is typically mounted on a platform. In this illustrative example, the platform is circuit board 30. Circuit board 30 is, in this illustrative example, a printed glass-epoxy type circuit board which includes conductive elements such as leads and pads (not shown). Conductive leads 20 in IC package 10 are secured to the conductive elements in circuit board 30 in a conventional manner such as by solder, alloying, gold eutectic bonding, conductive adhesive, non-conductive adhesive, and the like. IC package 10 and circuit board 30 form circuit pack 60. Circuit pack 60 may also include other electronic circuitry and components that are mounted on circuit board 30.

Heat sink 40 includes a plurality of heat dissipating elements in the form of individual plates 45 made of highly thermally conductive material. Such thermally conductive materials are well known by those skilled in the art, and include, for example, aluminum, graphite, boron nitride, berylia, tungsten, and the like. In some applications, it may be desirable to fabricate heat dissipating plates 45 from more than one thermally conductive material to form composite heat dissipating plates.

The size, shape, number, and position of individual heat dissipating plates 45 in heat sink 40 are selected using conventional heat sink design criteria that are known in the art. For example, the size, shape, and package type of IC package 10, the amount of heat it produces, the thermal conductivity of heat sink 40, the direction of flow of the cooling fluid if forced convection is utilized, the amount of cooling required in the particular application, and other factors may influence the physical design of individual heat dissipating plates 45 in heat sink 40. Such design criteria are described, for example, by A. D. Kraus and A. Bar-Cohen, Thermal Analysis and Control of Electronic Equipment, 1985. In this illustrative example, it is intended that heat dissipating plates 45 substantially surround the periphery of IC package 10. However, for convenience, several heat dissipating plates are not shown along the front and right edge of IC package 10 in FIG. 1 to allow other details to be illustrated, in particular conductive leads 20. It may be advantageous in some applications for heat dissipating plates 45 to only partially surround IC package 10, for instance, when utilizing natural convection cooling.

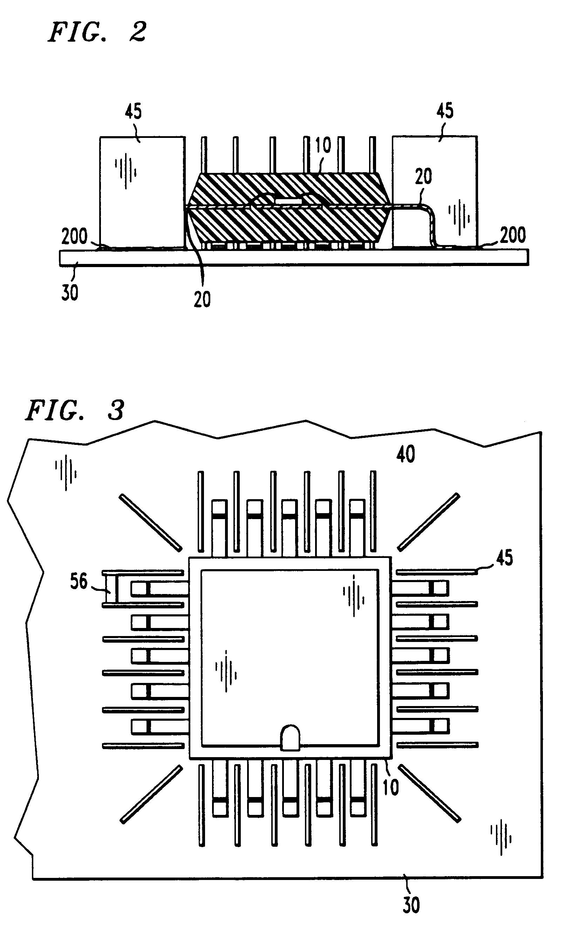

Heat sink 40 may be secured to circuit board 30 around the periphery of IC package 10 by means of a solder or an adhesive. The latter comprises an adhesive, such as epoxy, in which are dispersed particles of heat conductive material, such as copper, aluminum, etc. One such thermally conductive adhesive is available commercially as Thermobond 1600 produced by AAVID Engineering. Heat sink 40 may also be secured to circuit board 30 by means of mechanical fasteners such as screws, springs, or clips which puts the heat sink in intimate heat conductive contact with the circuit board. It will be appreciated by those skilled in the art that thermal joint compound (i.e., heat conductive grease), such as Thermalcote produced by Thermalloy Inc., may be advantageously utilized in some applications to further enhance the heat conductive contact between the heat sink and the circuit board. FIG. 2 is a cross-sectional view of the illustrative arrangement of FIG. 1 taken along line 2-2 in FIG. 1 showing adhesive 200 as the means for attaching heat sink 40 to circuit board 30.

FIG. 3 is a top view of the illustrative example of the invention shown in FIG. 1. FIG. 3 shows an illustrative arrangement where heat dissipating plates 45 are positioned around the entire periphery of electronic component 10. In some applications, it may be desirable to join each individual heat dissipating plate 45 to the adjoining heat dissipating plates using spacer 56 as shown to add mechanical strength to heat sink 40, or to faciliate the mounting of heat sink 40 to circuit board 30. Spacer 56 may be fashioned from any convenient material such as plastic or metal. For purposes of clarity, only a single exemplary spacer 56 is illustrated. Those skilled in the art will appreciate that the geometric configuration of spacer 56 may be readily determined according to the requirements of the specific application. The joining of the individual heat dissipating plates 45 to the adjoining heat dissipating plates may be realized, for example, using adhesive or mechanical devices such as bolts or screws.

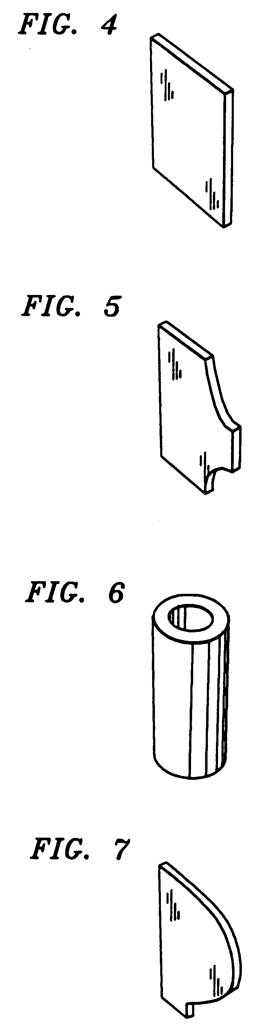

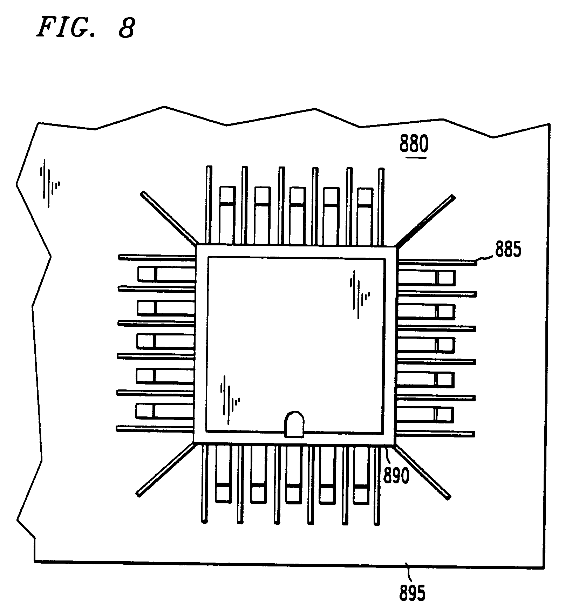

FIGs. 4, 5, 6, and 7 show various illustrative geometric configurations that surfaces of heat dissipating plates 45 may take in accordance with three example of the invention. FIG. 4 shows an exemplary heat dissipating plate 45 in a rectangular configuration. FIG. 5 shows a pin configuration where the pin may be solid or hollow. FIG. 6 shows a semicircular configuration. FIG. 7 shows a mixed geometrical configuration. Of course, those skilled in the art will be able to determine a configuration most appropriate for their specific application, including configurations not explicitly disclosed herein.

The attachment of heat sink 40 to circuit board 30 advantageously allows for improved heat transfer from IC package 10 to the surrounding cooling fluid, which is, in this example, air. As is appreciated by those skilled in the art, heat transfer from the surface of the chip in IC package 10 is dominated by conduction through the plastic housing encapsulating the chip, and along leadframe 16 to circuit board 30. In accordance with the principles of the invention, the attachment of heat sink 40 to circuit board 30 advantageously allows the heat conducted to circuit board 30 from IC package 10 to be to be readily dissipated to the surrounding cooling fluid by effectively increasing the surface area and thermal conductivity of circuit board 30. It has been observed, both empirically and through mathematical modeling, that up to 40-60% of the total heat produced by chips in typical plastic IC packages may be conducted through the leadframe to the circuit board. Thus, considerable additional cooling of IC package 10 over that provided by conventional heat sink designs is facilitated by the practice of the invention.

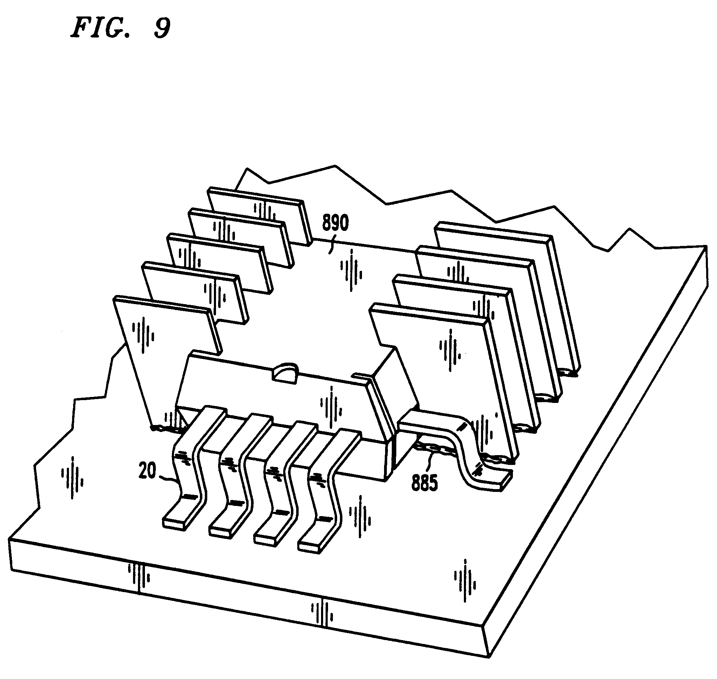

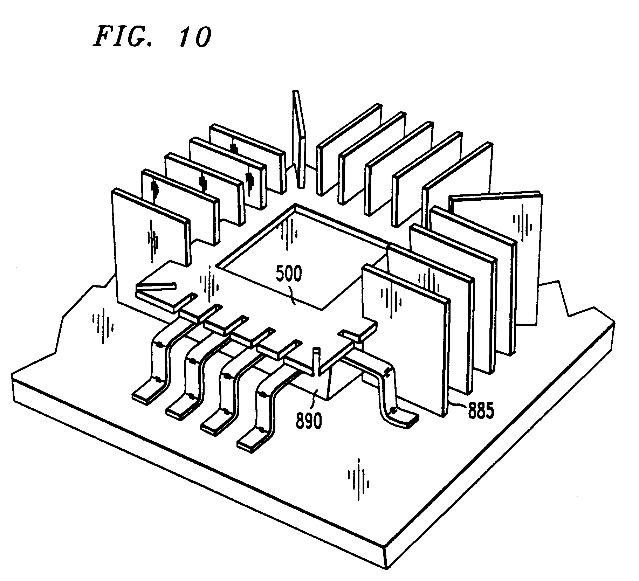

FIG. 8 shows another illustrative example of a heat sink in accordance with the invention. Heat dissipating plates 885 may take any of the various geometric configuations shown in FIGs. 4-7. In this example of the invention, the individual heat dissipating plates 885 are in heat conductive contact with both IC package 890 and circuit board 895. IC package 890 and circuit board 895 may be similar in form and operation as those elements shown in FIG. 1. It will be appreciated by those skilled in the art that the heat produced by a chip in IC package 890 is conducted through two paths to heat sink 880 where it is dissipated to the surrounding cooling fluid: the heat is conducted from the chip to the encapsulating plastic housing to heat sink 880, and from the chip to the leadframe to circuit board 895 to heat sink 880. Heat sink 880 may be attached to circuit board 895 using any of the mounting techniques discussed above. In some applications it may be desirable to secure heat sink 880 to IC package 890 using similar techniques. Alternatively, heat sink 880 may be secured to IC package 890, if so desired, by placing one edge of each individual heat dissipating plate 885 in a slot formed in the plastic package of IC package 890 as shown in FIG. 9. Heat dissipating plates 885 may be mechanically fastened or adhesively bonded in the slots. Or, the slots could have dimensions adapted so that a friction fit between the heat dissipating plates and the IC package is achieved thereby reducing or eliminating any need for adhesive or mechanical fastening. Those skilled in the art will appreciate that such slots may be molded into the plastic package during the manufacture of IC package 890, or, such slots could be added after the molding process using any convenient known fabrication process, for example, cutting, stamping, or the like. Alternatively, as shown in FIG. 10, the individual heat dissipating plates 885 may be retained by slotted retainer 500 which is placed in heat conductive contact with IC package 890. Slotted retainer 500 may be, for example, molded or fabricated from plastic or other highly thermally conductive material in one more pieces and attached to IC package 890 with epoxy or mechanically fastened using any of the techniques described above. Thermal joint compound may also be advantageously utilized in the interfaces between any or all of the elements discussed above to further enhance heat conductive contact between those elements.

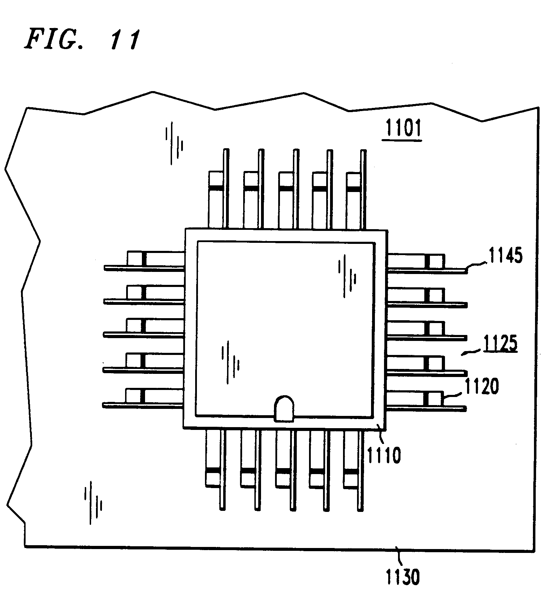

FIG. 11 shows another illustrative example of a heat sink in accordance with the invention. Heat sink 1101 is comprised of a plurality of heat dissipating plates 1145 mounted to circuit board 1130 in a similar fashion as in the illustrative example shown in FIG. 1. IC package 1110 and circuit board 1130 may be similar in form and function to those elements shown in FIG. 1. Heat dissipating plates 1145 may take any of the various geometric configuations shown in FIGs. 4-7. In this example of the invention, the individual heat dissipating plates 1145 are in heat conductive contact both with conductive leads 1120 forming leadframe 1125 and circuit board 1130. Advantageously, such contact allows for direct dissipation of the heat conducted to leadframe 1125 from the chip encapsulated in IC package 1110. Heat dissipating plates 1120 may take any of the various geometric configuations shown in FIGs. 4-7. In some applications it may be desirable to attach heat sink 1101 to leadframe 1125 using any of the attachment techniques described above. In addition, thermal joint compound may also be advantageously utilized in the interfaces between any or all of the elements discussed above to further enhance heat conductive contact between the elements.

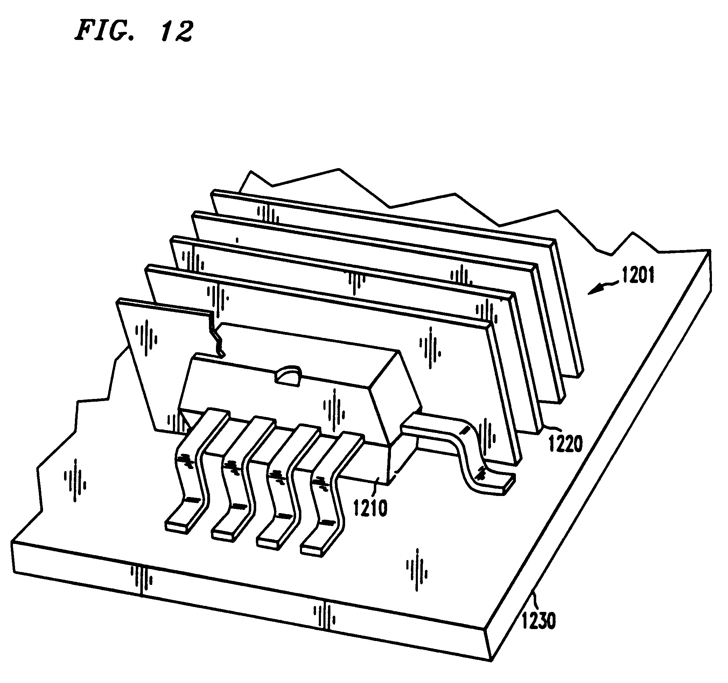

FIG. 12 shows another illustrative example of a heat sink in accordance with the invention. Heat sink 1201 is comprised of a plurality of heat dissipating plates 1220 mounted to circuit board 1230 in a similar fashion as in the illustrative example shown in FIG. 1. IC package 1210 and circuit board 1230 may be similar in form and function to those elements in FIG. 1. Heat dissipating plates 1220 may take any of the various geometric configuations shown in FIGs. 4-7. In this example, the individual heat dissipating plates 1220 are shaped to extend over, and contact, IC package 1210 so as to dissipate that heat generated by a chip in IC package 1210 which is conducted through the plastic housing. Thus, the heat produced by a chip in IC package 1210 is conducted through two paths to heat sink 1201 where it is dissipated to the surrounding cooling fluid: the heat is conducted from the chip to the top of encapsulating plastic housing in IC package 1210 to heat sink 1201, and from the chip to the leadframe to circuit board 1230 to heat sink 1201. It will be appreciated by those skilled in the art that the illustrative example shown in FIG. 12 may also be adapted so that the heat dissipating plates 1220 are also in heat conductive contact with the sides of IC package of 1210 and conductive leads 1220 in leadframe 1225 as discussed above while referring to FIG. 11. Thermal joint compound may also be advantageously utilized in the interfaces between any or all of the elements shown in FIG. 12 to further enhance heat conductive contact between those elements.

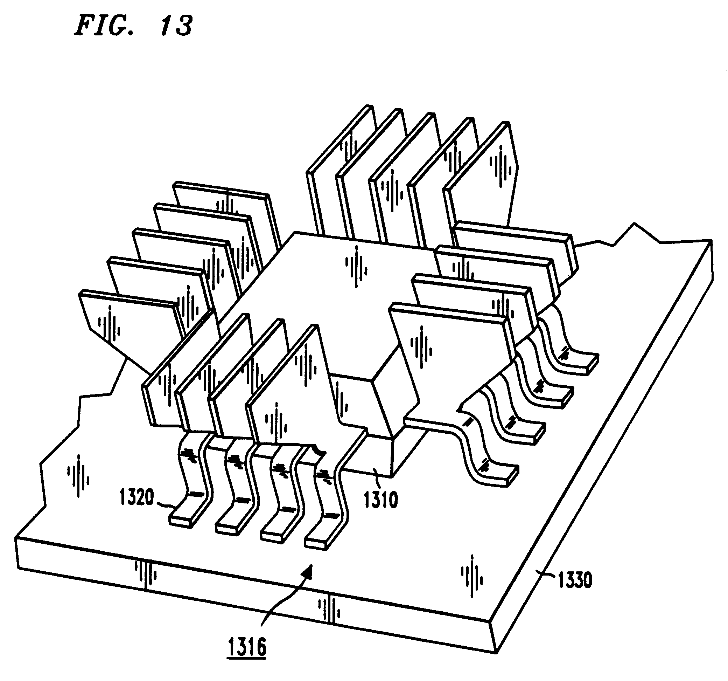

FIG. 13 shows an illustrative example of a leadframe with integrated extended surface in accordance with the invention. IC package 1310 and circuit board 1330 may be similar in form and operation as those elements shown in FIG. 1. Each conductive lead 1320 in leadframe 1316 may be integrated with an extended surface as shown in FIG. 13. The integrated extended surface could, for example, take any of the various geometric configurations shown in FIGs. 4-7. Such integration of the conductive lead with an extended surface advantageously allows a portion of the heat produced by a chip in IC package 1310 that is conducted to leadframe 1316 to be more effectively dissipated to the surrounding cooling fluid by virtue of the increased surface area of each conductive lead 1320. Alternatively, those skilled in the art will appreciate that such extended surfaces could be used, for example, to facilitate electrical connections with other components and devices. The extended surfaces could also be used mechanically to accomodate other packaging requirements, for example, by providing a convenient grasping point to facilitate the mounting of IC package 1310 on circuit board 1330.

It will be understood that the particular techniques described above are only illustrative of the principles of the present invention, and that various modifications could be made by those skilled in the art without departing from the scope and spirit of the present invention, which is limited only by the claims that follow. For example the invention may be readily applied to IC connections, other than IC to circuit board connections, such as IC to multichip modules, IC to socket, and other platforms.

## Claims

1. Apparatus comprising:
a heat dissipative element adjacent to a heat-producing component so as to dissipate heat transferred to a platform by the component.

2. Circuit pack apparatus comprising:
at least one electronic component encapsulated in a package mounted on a circuit board;
at least one single piece of thermally and electrically conductive material connecting the electronic component to the circuit board having
a first and second end;
a conductive path between the ends for conducting a signal between the electronic chip and the circuit board; and
an extended surface integrally formed with the material and positioned on the path external to the encapsulating package.

3. The apparatus of claim 2 in which the extended surface comprises a heat dissipating plate.

4. The apparatus of claim 1, in which the heat dissipative element comprises a plurality of individual plates of at least one thermally conductive material.

5. The apparatus of claim 4, in which the plurality of individual plates substantially or partially surround the heat-producing component.

6. The apparatus of claim 2, 3, 4 or 5, in which the heat dissipating plate or at least one of the plurality of individual plates has a surface substantially rectangular or substantially semicircular in shape, or is shaped as a pin selected from solid cylinders, or tubes.

7. The apparatus of claim 3 or 4, in which a portion of the heat dissipating plate or at least one of the plurality of individual plates has a surface with a substantially circular shape, or is shaped as a pin selected from solid cylinders or tubes.

8. The apparatus of claim 1, in which the heat dissipative element is in heat conductive contact either with a leadframe of the heat-producing component, or with the heat producing component.

9. The apparatus of claim 8, further including means for attaching the heat dissipative element to the heat-producing component.

10. The apparatus of claim 9, in which the means for attaching either comprises a retainer having at least one slot for receipt of the heat dissipating element where the retainer is in heat conducting contact with the heat-producing component, or comprises a slot in the heat-producing component.

11. The apparatus of claim 1, 4 or 5, in which the platform is a multichip module, a socket, or a circuit board.

12. A circuit pack comprising:
a circuit board;
at least one heat-producing device mounted on the circuit board; and
a heat dissipative element mounted on the circuit board adjacent to the component so as to dissipate heat transferred to the circuit board by the component.

13. A method comprising the step of:
mounting a heat dissipative element adjacent to a heat-producing component so as to dissipate heat transferred to a platform by the component, the platform optionally being a multichip module, a socket or a circuit board.

14. A method of cooling a circuit pack comprising a circuit board and at least one heat-producing component comprising the step of:
mounting a heat dissipative element on the circuit board adjacent to the component so as to dissipate heat transferred to the circuit board by the component.
